# FASCICULE DE BREVET EUROPEEN

(11) **EP 2 294 472 B1**
(45) Date de publication et mention de la délivrance du brevet: **21.08.2013**
(21) Numéro de dépôt: 08805913.4
(22) Date de dépôt: 02.06.2008
(51) Int. Cl.: G02B 26/08

(54) **MICROMIROIR A ACTIONNEMENT ELECTROMAGNETIQUE**
MIKROSPIEGEL MIT ELEKTROMAGNETISCHER BETÄTIGUNG
MICROMIRROR WITH ELECTROMAGNETIC ACTUATION

(43) Date de publication de la demande: 16.03.2011
(73) Titulaire: Lemoptix SA, 1185 Mont-sur-Rolle (CH)
(72) Inventeur: ABELE, Nicolas, CH-1005 Lausanne (CH); KHECHANA, Faouzi, CH-1023 Crissier (CH)
(74) Mandataire: de Beaumont, Michel
(86) Numéro de dépôt international: PCT/FR2008/050970
(87) Numéro de publication internationale: WO 2009/147304

(56) Documents cités:
- EP-A- 1 207 416
- DE-A1- 19 803 857
- US-A1- 2003 123 128
- US-A1- 2005 002 085
- US-A1- 2007 089 973

## Description

### Domaine de l'invention

La présente invention concerne les micromiroirs mobiles formés par des techniques de fabrication de structures microélectromécaniques (MEMS). La présente invention concerne plus particulièrement une nouvelle structure de micromiroir à actionnement électromagnétique.

### Exposé de l'art antérieur

Des micromiroirs mobiles réalisés en technologie MEMS sont utilisés dans de nombreux dispositifs, tels que, par exemple, des appareils d'imagerie médicale, des spectromètres optiques ou encore des capteurs de lumière visible ou infrarouge tels que des lecteurs de codes-barres.

On considère ici des micromiroirs fixés à un cadre par un axe et orientables autour de cet axe par des moyens électromagnétiques.

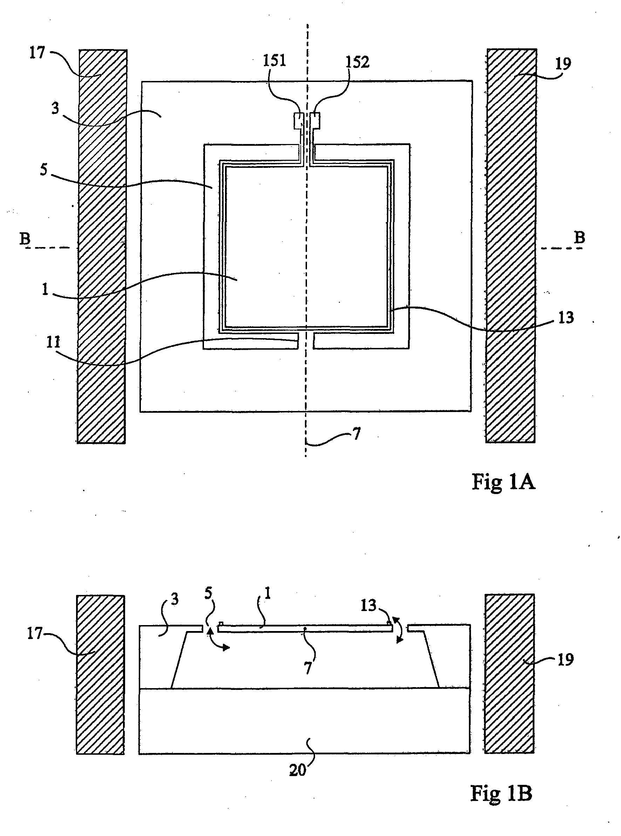

Les figures 1A et 1B illustrent en vue de dessus et en vue en coupe selon le plan B-B un micromiroir. Le micromiroir comporte une plaquette réfléchissante 1. La plaquette 1 est fixée à un cadre 3. Le cadre 3, généralement constitué d'une portion d'une tranche de silicium, est séparé de la plaquette 1 par un intervalle vide 5. La plaquette 1 est fixée au cadre 3 par deux bras 9 et 11 alignés symétriquement de part et d'autre de la plaquette 1 le long d'un même axe 7. La plaquette 1 est mobile en rotation autour de l'axe 7. Une piste conductrice 13 suit la périphérie de la face avant de la plaquette 1. La piste conductrice 13 passe par un bras 9 et se termine par des plots 151 et 152 formés sur le cadre 3 et propres à être reliés à une alimentation non représentée de façon qu'un courant circule dans la piste conductrice 13. L'ensemble du cadre 3 et de la plaquette 1 est placé entre deux aimants 17 et 19. Les aimants 17 et 19 sont placés symétriquement de part et d'autre de l'axe 7. Ainsi, les aimants 17 et 19 créent un champ magnétique dont les lignes de champs sont perpendiculaires à l'axe 7. Lorsqu'un courant parcourt La piste conductrice 13, des forces de Lorentz opposées s'exercent sur les portions de la piste 13 parallèles à l'axe 7 et dans lesquelles circulent des courants opposés. Ceci provoque une rotation de la plaquette 1 autour de son axe 7. La rotation, indiquée par des flèches en figure 1B, présente une direction et un angle déterminés par le sens et l'intensité du courant parcourant la piste conductrice 13. Il est donc possible de moduler l'orientation et l'inclinaison de la plaquette 1 en faisant varier le signe et la valeur de la tension appliquée entre les plots 151 et 152.

L'ensemble du micromiroir est fixé sur un support 20 qui ferme en partie basse la cavité du cadre 3 dans laquelle la plaquette 1 est mobile autour de son axe 7. De plus, un capot (non représenté) fixé sur le cadre 3 protège la plaquette 1 de l'intrusion de contaminants.

Un tel micromiroir présente plusieurs inconvénients. Un premier inconvénient réside dans l'encombrement lié au placement des aimants 17 et 19. Un autre inconvénient réside dans le fait que ces aimants 17 et 19, en raison de leur éloignement de la plaquette 1, doivent fournir un champ intense pour obtenir un déplacement significatif du miroir sans consommation excessive d'énergie. En pratique, la plaquette 1 est un carré d'environ un millimètre de côté, l'intervalle 5 fait environ 20 µm et entre le bord intérieur du cadre 3 côté plaquette 1 et le bord en regard de chacun des aimants 17 et 19, la distance est d'environ un millimètre. Ainsi, pour garantir un champ suffisant dans la zone de la plaquette 1, les aimants 17 et 19 doivent avoir des dimensions de l'ordre de 2 mm de largeur, 1,5 mm d'épaisseur et 4 mm de longueur. L'encombrement des micromiroirs est donc au moins doublé par rapport au cas où les aimants seraient absents. Cela nuit à la miniaturisation des dispositifs utilisant ces micromiroirs et complique la mise en place des micromiroirs dans des dispositifs complexes.

Un autre inconvénient est que pour limiter l'encombrement, on tend à limiter la taille des aimants 17 et 19. La valeur du champ appliqué à la plaquette 1 est donc limitée. Pour obtenir une variation donnée de l'inclinaison de la plaquette 1, il faut alors faire passer dans la piste conductrice 13 un courant relativement élevé. Cela complique le système car il faut alors tenir compte de la dissipation de puissance correspondante dans la piste conductrice 13.

### Résumé de l'invention

La présente invention vise un micromiroir actionné magnétiquement qui ne présente pas les inconvénients des micromiroirs connus.

Ainsi, la présente invention prévoit un micromiroir comportant une plaquette réfléchissante mobile en rotation autour d'un axe et fixée à un cadre par deux bras parallèles alignés de part et d'autre de la plaquette de façon à former l'axe, l'ensemble du cadre et de la plaquette étant fixé sur un support, le micromiroir comportant deux couches aimantées distinctes (39, 40 ; 72, 73) parallèles et symétriques par rapport à l'axe de rotation (32).

Selon l'invention, le micromiroir porte, à la périphérie de la face avant de la plaquette, au moins une piste conductrice formant au moins une boucle et susceptible d'être parcourue par un courant.

Selon l'invention, les couches aimantées sont placées sur des parois latérales internes d'un capot posé sur le cadre de façon à protéger la face avant de la plaquette, la face supérieure du capot étant transparente.

Selon un mode de réalisation de l'invention, des couches ferromagnétiques s'étendent perpendiculairement aux couches aimantées entre les extrémités des couches aimantées.

Selon un mode de réalisation de l'invention, la couche aimantée est une couche aimantée de samarium-cobalt ou de néodyme-fer-bore.

### Brève description des dessins

Ces objets, caractéristiques et avantages, ainsi que d'autres seront exposés en détail dans la description suivante d'exemples de réalisation particuliers faite à titre nonlimitatif en relation avec les figures jointes parmi lesquelles :
les figures 1A et 1B, précédemment décrites, illustrent un exemple de micromiroir classique ;
la figure 2A illustre en vue de dessus un micromiroir ;
la figure 2B est une vue en coupe illustrant le micromiroir de la figure 2A ;
la figure 3 est une vue en coupe illustrant un micromiroir; et
la figure 4 est une vue en coupe illustrant un micromiroir selon un autre mode de réalisation de l'invention.

### Description détaillée

Par souci de clarté, comme cela est habituel dans la représentation des microsystèmes, les diverses figures ne sont pas tracées à l'échelle.

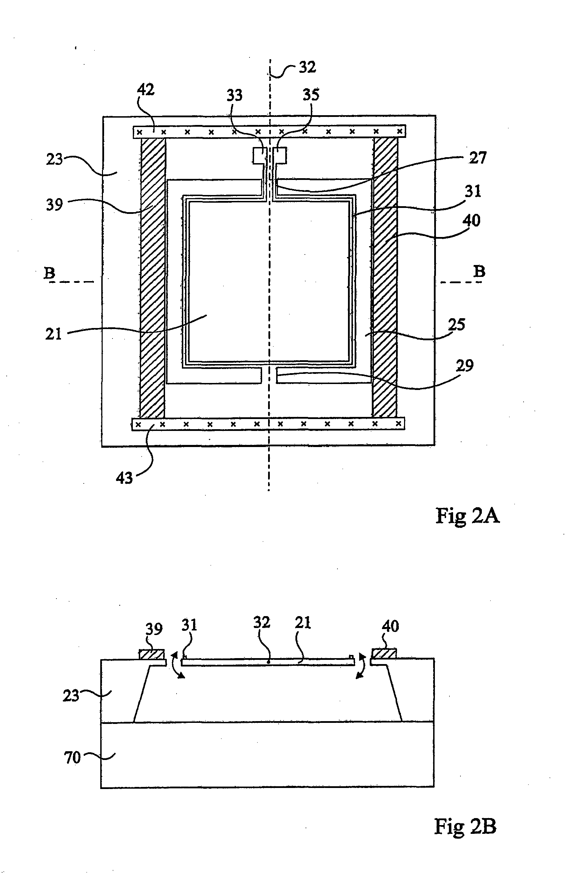

La figure 2A illustre en vue de dessus un micromiroir. La figure 2B est une vue en coupe de la figure 2A selon le plan B-B.

Le micromiroir comporte une plaquette réfléchissante 21 fixée à un cadre 23. Un intervalle vide 25 sépare la plaquette 21, par exemple en un matériau semiconducteur monocristallin tel que le silicium, du cadre 23. Le cadre 23 est par exemple constitué d'une portion de tranche semiconductrice par exemple de silicium. La plaquette 21 est fixée au cadre 23 par deux bras 27 et 29 alignés le long d'un même axe 32 de part et d'autre de la plaquette 21. La plaquette 21 est mobile autour de l'axe 32. L'ensemble du micromiroir est fixé sur un support 70 qui ferme en partie basse la cavité du cadre 23 dans laquelle la plaquette 21 est mobile autour de son axe 32. Le support 70 est par exemple un substrat de verre, de silicium ou de silicium sur isolant.

Une piste conductrice 31 suit la périphérie de la face avant de la plaquette 21 de façon à former une boucle. Les deux extrémités de la piste conductrice 31 passent par un même bras, par exemple le bras 27, pour atteindre le cadre 23 où elles se terminent par des plots 33 et 35 connectables à une source de tension non représentée.

Selon un mode de réalisation, deux aimants identiques distincts 39 et 40 sont formés en couches minces sur la face avant du cadre 23 à la limite de l'intervalle 25. Les aimants 39 et 40 sont formés parallèlement sur les deux bords du cadre 23 parallèles à l'axe 32, c'est-à-dire les bords auxquels les bras 27 et 29 ne sont pas fixés. Les deux couches d'aimant 39 et 40 sont constituées de samarium-cobalt ou de néodyme-fer-bore déposé sous un champ magnétique ou magnétisé à la suite de leur dépôt.

Comme cela ressort d'une comparaison entre les figures 2A et 2B et les figures 1A et 1B, les couches aimantées 39 et 40 peuvent être placées beaucoup plus près des bords de la plaquette mobile 21 que les aimants 17 et 19. Ceci permet de réduire à la taille du cadre 23 l'encombrement d'un micromiroir à actionnement magnétique.

Les aimants 39 et 40 sont à proximité immédiate de la plaquette 21, séparés de celle-ci uniquement par l'intervalle 25 de 20 à 40 µm. Toutes choses égales d'ailleurs, l'espace entre eux est réduit à environ 1,5 mm au lieu de 2 à 2,5 mm dans le dispositif classique. Les déperditions sont réduites et le champ appliqué au niveau de la plaquette 21 est plus élevé. Pour obtenir un déplacement donné de la plaquette 21, le courant qui circule dans la piste conductrice 31 est réduit par rapport à la valeur nécessaire pour obtenir un même déplacement avec le dispositif des figures 1A et 1B.

Selon un mode de réalisation, également illustré en figures 2A et 2B, à chacune des deux extrémités des couches aimantées 39 et 40, une couche 42, 43 s'étend perpendiculairement aux couches aimantées 39 et 40 d'une couche aimantée à une autre. Les couches 42 et 43 sont en un matériau ferromagnétique propre à éviter la dispersion des lignes du champ magnétique formé entre les couches aimantées 39 et 40.

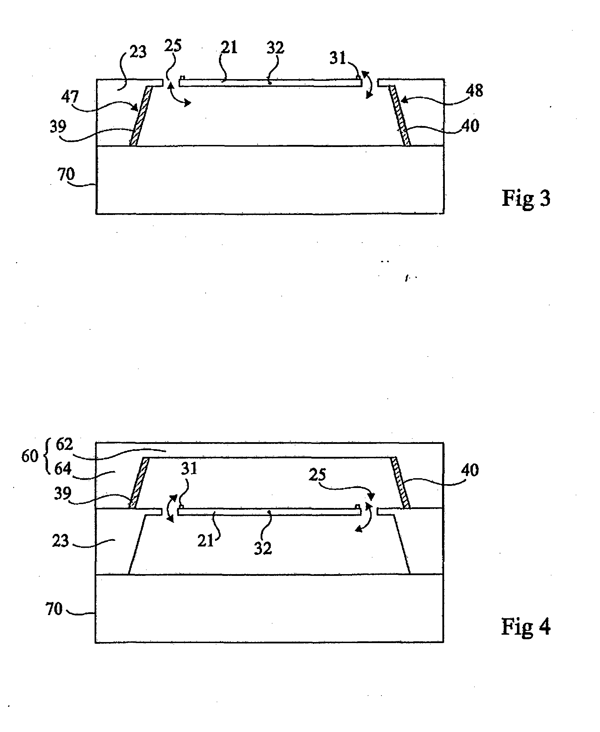

La figure 3 est une vue en coupe illustrant un autre mode de réalisation d'un micromiroir. Par souci de clarté, seules les différences avec la figure 2B seront détaillées. Les couches aimantées 39 et 40 sont déposées sur des parois latérales 47 et 48 du cadre 23 dans l'intervalle 25. Les parois 47 et 48 sont parallèles à l'axe 32.

Placer les couches minces aimantées 39 et 40 sur les parois 47 et 48 permet avantageusement de ne pas encombrer la surface du cadre 23 en profitant d'un espace normalement inutile.

En outre, former les couches minces 39 et 40 sur les parois 47 et 48 présente un avantage sur le plan du procédé de fabrication. Pour obtenir une aimantation voulue, il faut un certain volume de matière et la surface disponible sur les parois 47 et 48 est nettement supérieure à la surface disponible sur le dessus du cadre 23. Il est alors possible de réduire l'épaisseur des couches aimantées 39 et 40. Or le temps de dépôt est d'autant plus long que l'épaisseur déposée est importante. Réduire l'épaisseur des couches aimantées 39 et 40 constitue un gain de temps important ce qui réduit le coût de fabrication du dispositif.

La figure 4 est une vue en coupe illustrant un autre mode de réalisation d'un micromiroir selon l'invention. Par souci de clarté, seules les différences avec la vue en coupe de la figure 2B sont exposées.

Comme cela a été mentionné précédemment, le micromiroir est surmonté d'un capot 60 destiné à protéger la plaquette 21. Le capot 60 comporte une surface supérieure 62 transparente à l'aplomb de la plaquette réfléchissante 21. La surface 62 est soutenue par des montants 64 qui s'appuient sur le cadre 23. Les montants 64 sont périphériques à la plaquette 21 et scellent une cavité dans laquelle la plaquette 21 est orientable autour de son axe 32.

Les couches d'aimant 39 et 40 sont formées à l'intérieur de la cavité sur les montants 64 parallèles à l'axe 32.

La formation des couches 39 et 40 sur les montants 64 permet, comme dans le mode de réalisation de la figure 3, de ne pas encombrer la surface du cadre 23 en profitant d'une place normalement perdue tout en réduisant les coûts de fabrication.

Des modes de réalisation particuliers de la présente invention ont été décrits. Diverses variantes et modifications apparaîtront à l'homme de l'art. En particulier, les matériaux utilisés peuvent différer en fonction d'une filière technologique considérée. Ainsi, on a supposé que le cadre 23 est une portion de tranche de silicium. Toutefois, il peut s'agir d'une portion de tranche de silicium sur isolant ou d'un autre semiconducteur. De même, la plaquette 21 a été considérée à titre d'exemple non limitatif comme étant une plaquette de silicium monocristallin. La plaquette 21 peut être en un quelconque matériau réfléchissant. De façon similaire, les matériaux des capot 60 et support 70 peuvent être adaptés en fonction de la filière technologique de fabrication utilisée.

Par ailleurs, l'homme de l'art comprendra que dans les modes de réalisation des figures 3 et 4 il est possible mutatis mutandis de former des couches ferromagnétiques similaires aux couches 42 et 43 du mode de réalisation de la figure 2. Leur emplacement est alors modifié de façon approprié par rapport au mode de réalisation de la figure 2 en fonction de la modification d'emplacement des couches aimantées.

De plus, dans les modes de réalisation des figures 2A-B, 3 et 4, une seule piste 31 a été représentée comme formant une unique boucle. Toutefois, la piste 31 peut former plusieurs boucles, ou la plaquette 21 peut porter plusieurs pistes formant chacune une boucle.

De façon similaire, on a supposé que les extrémités de la piste 31 passent par un même bras 27 pour atteindre le cadre 23. Toutefois, chaque extrémité peut passer par un bras différent.

## Revendications

1. Micromiroir comportant une plaquette réfléchissante (21) mobile en rotation autour d'un axe (32) et fixée à un cadre (23) par deux bras parallèles (27, 29) alignés de part et d'autre de la plaquette de façon à former l'axe, la périphérie de la face avant de la plaquette (21) portant au moins une piste conductrice (31) formant au moins une boucle susceptible d'être parcourue par un courant, l'ensemble du cadre et de la plaquette étant fixé sur un support (70), le micromiroir comportant deux couches aimantées distinctes (39, 40) parallèles et symétriques par rapport à l'axe de rotation (32), carestérisé en ce que les couches aimantées sont placées sur des parois latérales internes (64) d'un capot (60) posé sur le cadre (23) de façon à protéger la face avant de la plaquette, la face supérieure du capot étant transparente.

2. Micromiroir selon la revendication 1, dans lequel des couches ferromagnétiques (42, 43) s'étendent perpendiculairement aux couches aimantées (39, 40) entre les extrémités des couches aimantées.

3. Micromiroir selon la revendication 1 ou 2, dans lequel la couche aimantée (39, 40) est une couche aimantée de samarium-cobalt ou de néodyme-fer-bore.

## Patentansprüche

1. Ein Mikrospiegel, der folgendes aufweist:
eine reflektierende Platte (21) drehbeweglich um eine Achse (32) und angebracht an einem Rahmen (23) durch zwei parallele Arme (27, 29) ausgerichtet auf jede Seite der Platte zur Bildung der Achse, wobei der Umfang bzw. die Peripherie der vorderen Oberfläche der Platte (21) mindestens eine leitende Spur (31) trägt, die mindestens eine Schleife bildet, die in der Lage ist einen Strom zu leiten, wobei die durch den Rahmen und die Platte gebildete Anordnung an einem Träger (70) angebracht ist, wobei der Mikrospiegel zwei gesonderte Magnetschichten (39, 40), und zwar parallel zu einander und symmetrisch bezüglich der Drehachse (32) aufweist, **dadurch gekennzeichnet, dass** Magnetschichten auf inneren Seitenwänden (64) einer Abdeckung (60) angeordnet sind, die auf dem Rahmen (23) gelegt ist, um die vordere Oberfläche der Platte zu schützen, wobei die obere Oberfläche (Oberseite) der Abdeckung transparent ist.

2. Mikrospiegel nach Anspruch 1, wobei ferromagnetische Schichten (42, 43) sich senkrecht zu den Magnetschichten (39, 40) zwischen den Enden der Magnetschichten erstrecken.

3. Mikrospiegel nach Anspruch 1 oder 2, wobei die Magnetschicht (39, 40) eine Samarium-Kobalt oder Neodym-Eisen-Bor-Magnetschicht ist.

## Claims

1. A micromirror comprising a reflective plate (21) rotatably mobile around an axis (32) and attached to a frame (23) by two parallel arms (27, 29) aligned on either side of the plate to form the axis, the periphery of the front surface of the plate (21) supporting at least one conductive track (31) forming at least one loop capable of conducting a current, the assembly formed by the frame and the plate being attached to a support (70), the micromirror comprising two separate magnetic layers (39, 40) parallel to each other and symmetrical with respect to the rotation axis (32), **characterized in that** the magnetic layers are placed on internal lateral walls (64) of a cover (60) laid on the frame (23) to protect the front surface of the plate, the upper surface of the cover being transparent.

2. The micromirror of claim 1, wherein ferromagnetic layers (42, 43) extend perpendicularly to the magnetic layers (39, 40) between the ends of the magnetic layers.

3. The micromirror of claim 1 or 2, wherein the magnetic layer (39, 40) is a samarium-cobalt or neodymium-iron-boron magnetic layer.
